# EUROPEAN PATENT SPECIFICATION

(11) **EP 4 212 925 B1**
(45) Date of publication and mention of the grant of the patent: **19.03.2025**
(21) Application number: 20957585.1
(22) Date of filing: 12.10.2020
(51) Int. Cl.: H01L 27/146, H04N 25/13

(54) **IMAGING ELEMENT AND IMAGING DEVICE**
BILDGEBUNGSELEMENT UND BILDGEBUNGSVORRICHTUNG
ÉLÉMENT D'IMAGERIE ET DISPOSITIF D'IMAGERIE

(43) Date of publication of application: 19.07.2023
(73) Proprietor: Nippon Telegraph And Telephone Corporation, Chiyoda-ku Tokyo 100-8116 (JP)
(72) Inventor: MIYATA, Masashi, Musashino-shi, Tokyo 180-8585 (JP); NEMOTO, Naru, Musashino-shi, Tokyo 180-8585 (JP); NAKAJIMA, Mitsumasa, Musashino-shi, Tokyo 180-8585 (JP); HASHIMOTO, Toshikazu, Musashino-shi, Tokyo 180-8585 (JP)
(74) Representative: Hoffmann Eitle
(86) International application number: PCT/JP2020/038458
(87) International publication number: WO 2022/079756

(56) References cited:
- WO-A1-2013/094178
- WO-A1-2018/092632
- JP-A- 2007 335 723
- JP-A- 2009 157 390
- JP-A- 2010 232 595
- JP-A- 2012 015 424
- JP-A- 2014 033 052
- JP-A- 2019 184 986
- JP-A- 2020 051 868
- US-A1- 2009 141 153
- US-A1- 2015 365 640
- US-A1- 2016 064 448
- US-A1- 2017 179 178

## Description

### [Technical Field]

The present disclosure relates to an imaging element and an imaging apparatus.

### [Background Art]

In an imaging apparatus, incidence angles of light are known to differ between a central portion and an outer peripheral portion of an imaging element (for example, refer to PTL 1).

### [Citation List]

### [Patent Literature]

[PTL 1] Japanese National Publication of International Patent Application No. 2006-528424 A.

US 2015/0365640 A1 refers to an image pickup apparatus including a colour separation element array. The colour separation elements are arranged two dimensionally and configured to separate incident light according to a wavelength so that the light of a first wavelength and a second wavelength are directed into different directions. The colour separation elements comprise first and second partitions that are sequentially arranged along a travelling direction of the incident light.

US 20160064448 A1 refers to an image sensor having a photosensor layer and a plurality of photo sensing cells. A color separation layer disposed on the photo sensor layer and including color separation elements embedded in a transparent spacer layer. A micro lens array is arranged on the color separation layer, the micro lens array including a plurality of micro lenses. The color separation layer separates light by wavelength. The micro lens array concentrates incident light onto the plurality of color separation elements.

US200902141153A1 refers to a solid-state imaging device to capture an image which is bright through to its periphery when used in a single-lens reflex digital camera that accepts various interchangeable lenses from wide-angle to telephoto. a two-dimensional array of unit pixels includes a light collecting element. The light collecting element is a combination of circular sector shaped light collecting elements having different concentric structures.

### [Summary of Invention]

### [Technical Problem]

There is a problem in that, when an incidence angle deviates, light cannot be efficiently guided to a conversion element and light-receiving efficiency decreases.

An aspect of the present disclosure is to enable light-receiving efficiency to be improved.

### [Solution to Problem]

The aims of the invention are achieved by the subject matter of independent claim one. Advantageous embodiments of the invention are disclosed in the dependent claims. An imaging element according to an aspect includes: a plurality of photoelectric conversion element groups each including a plurality of photoelectric conversion elements and being arranged in a two-dimensional direction; a transparent layer which faces the plurality of photoelectric conversion element groups and which extends in the two-dimensional direction as a planar direction; and a plurality of structure groups arranged in a planar direction of the transparent layer so as to correspond to the plurality of photoelectric conversion element groups on the transparent layer or inside the transparent layer, wherein each of the plurality of structure groups includes a plurality of structures arranged in a same pattern and is arranged so as to disperse incident light toward each of the photoelectric conversion elements of a corresponding photoelectric conversion element group, and in a plan view, relative positions of the corresponding photoelectric conversion element group and a structure group differ according to two-dimensional positions.

An imaging apparatus according to an aspect includes the imaging element described above and a signal processing unit configured to generate an image signal based on an electric signal obtained from the imaging element.

### [Advantageous Effects of Invention]

According to the present disclosure, light-receiving efficiency can be improved.

### [Brief Description of Drawings]

[Fig. 1]

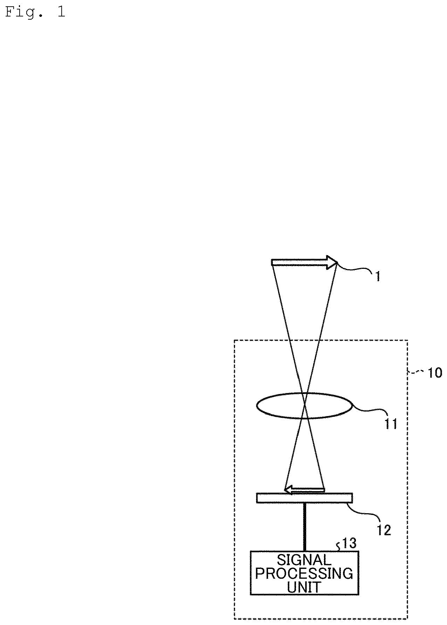

   Fig. 1 is a diagram showing an example of a schematic configuration of an imaging element and an imaging apparatus according to an embodiment.
[Fig. 2]

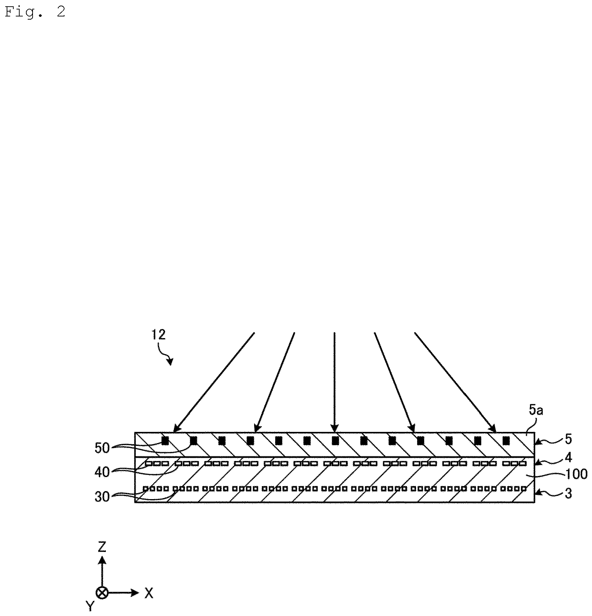

   Fig. 2 is a diagram showing an example of a schematic configuration of an imaging element.
[Fig. 3]

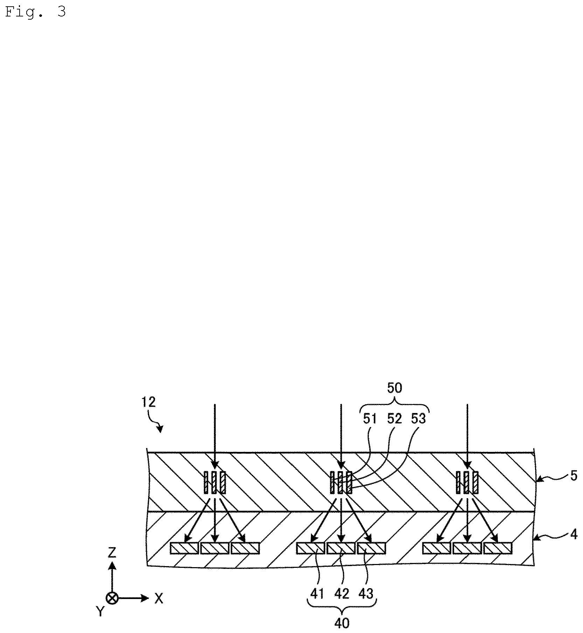

   Fig. 3 is a diagram showing an example of a schematic configuration of an imaging element in a central portion.
[Fig. 4]

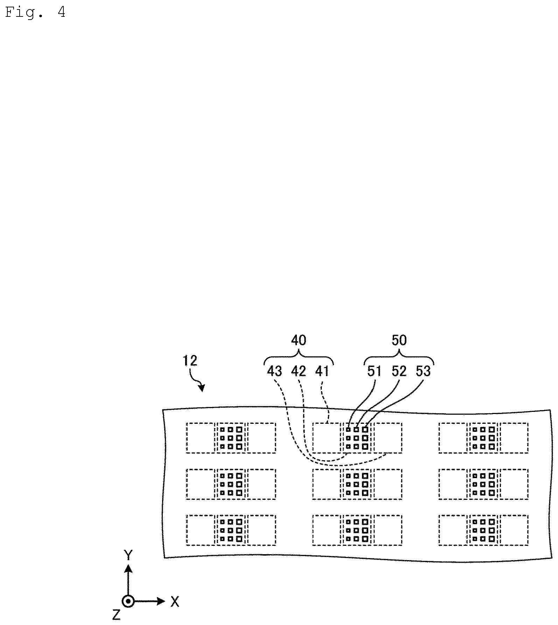

   Fig. 4 is a diagram showing an example of a schematic configuration of an imaging element in a central portion.
[Fig. 5]

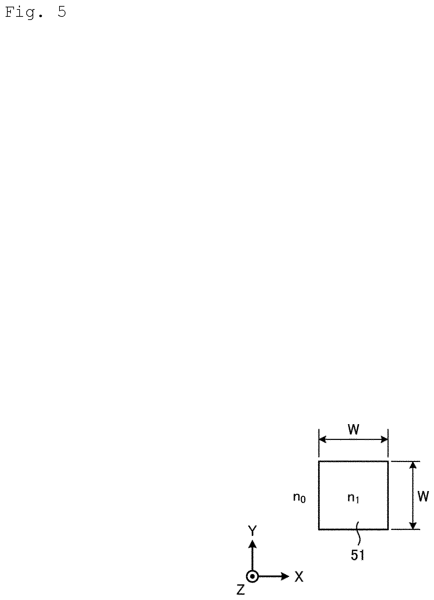

   Fig. 5 is a diagram showing an example of a schematic configuration of a structure.
[Fig. 6]

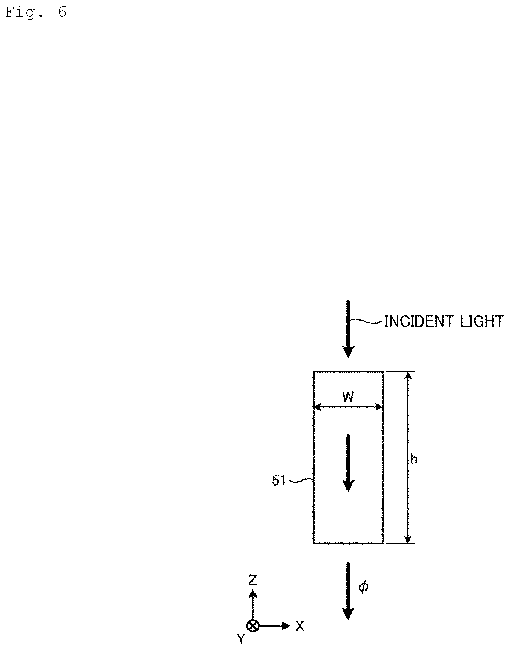

   Fig. 6 is a diagram showing an example of a schematic configuration of a structure.
[Fig. 7]

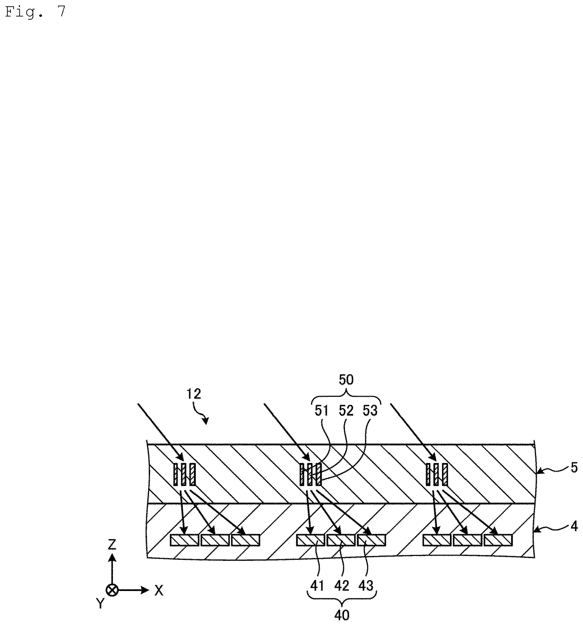

   Fig. 7 is a diagram showing an example of a schematic configuration of an imaging element in an outer peripheral portion.
[Fig. 8]

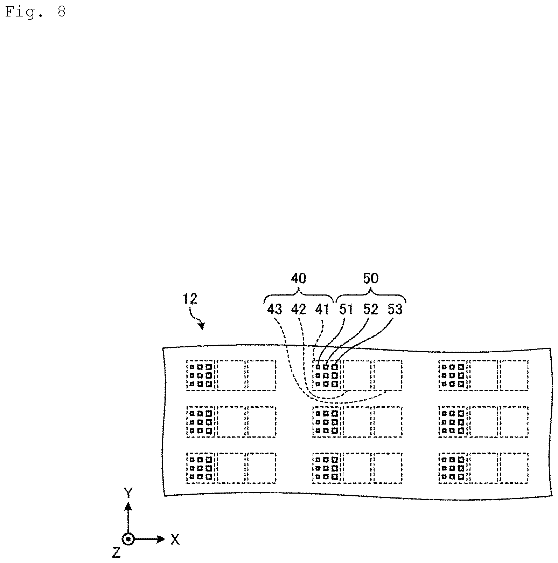

   Fig. 8 is a diagram showing an example of a schematic configuration of an imaging element in an outer peripheral portion.
[Fig. 9]

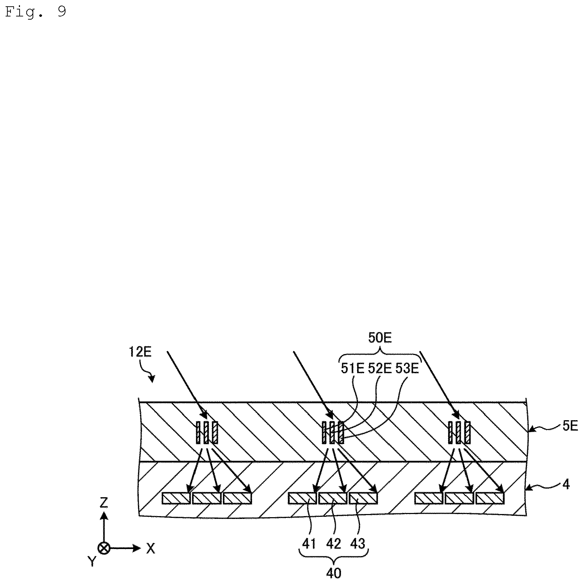

   Fig. 9 is a diagram showing a comparative example.
[Fig. 10]

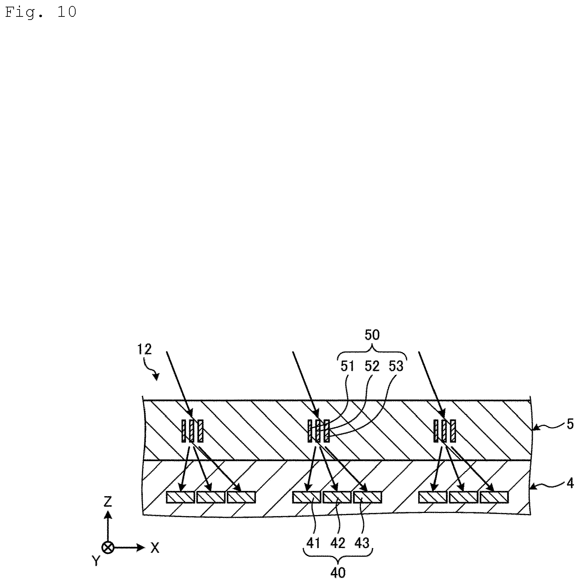

   Fig. 10 is a diagram showing an example of a schematic configuration of an imaging element in an intermediate portion.
[Fig. 11]

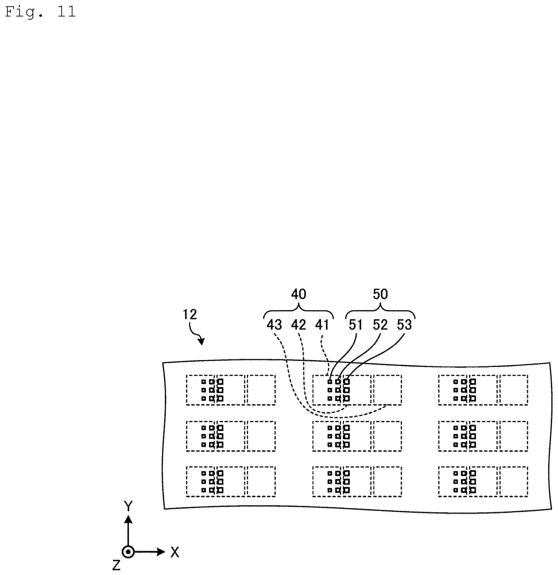

   Fig. 11 is a diagram showing an example of a schematic configuration of an imaging element in an intermediate portion.
[Fig. 12]

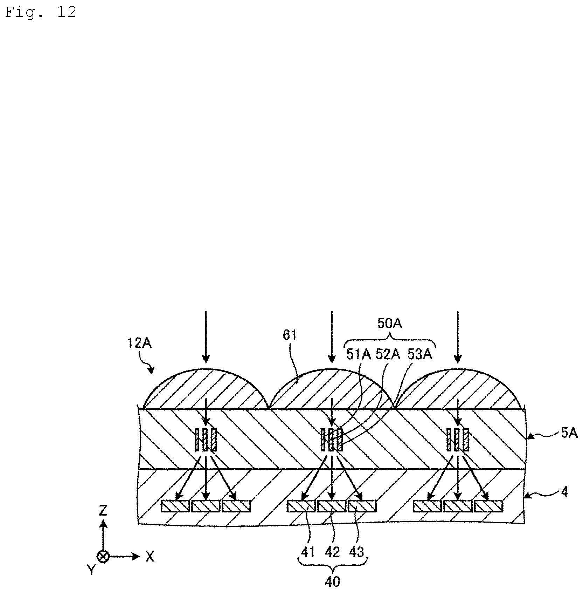

   Fig. 12 is a diagram showing an example of a schematic configuration of an imaging element in a central portion.
[Fig. 13]

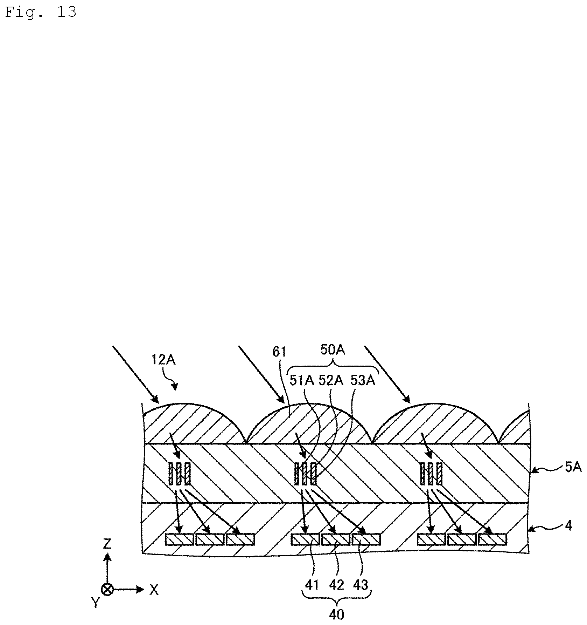

   Fig. 13 is a diagram showing an example of a schematic configuration of an imaging element in an outer peripheral portion.
[Fig. 14]

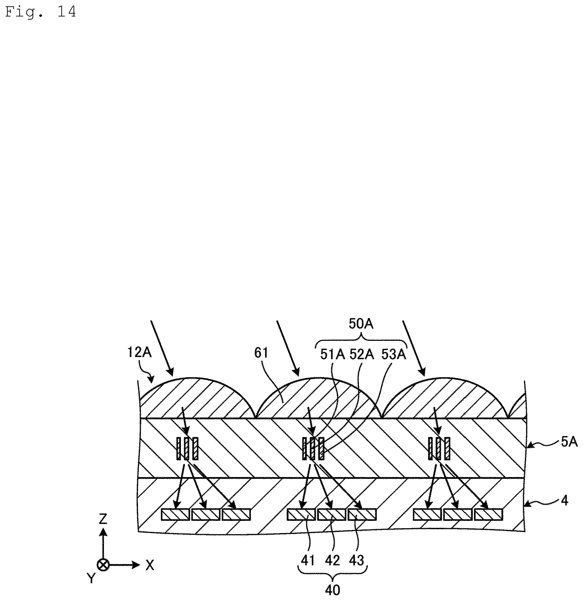

   Fig. 14 is a diagram showing an example of a schematic configuration of an imaging element in an intermediate portion.
[Fig. 15]

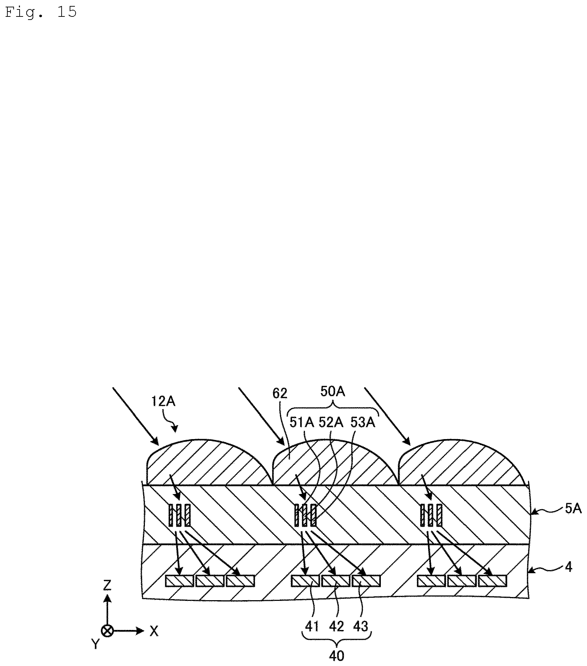

   Fig. 15 is a diagram showing an example of a schematic configuration of an imaging element in an outer peripheral portion.
[Fig. 16]

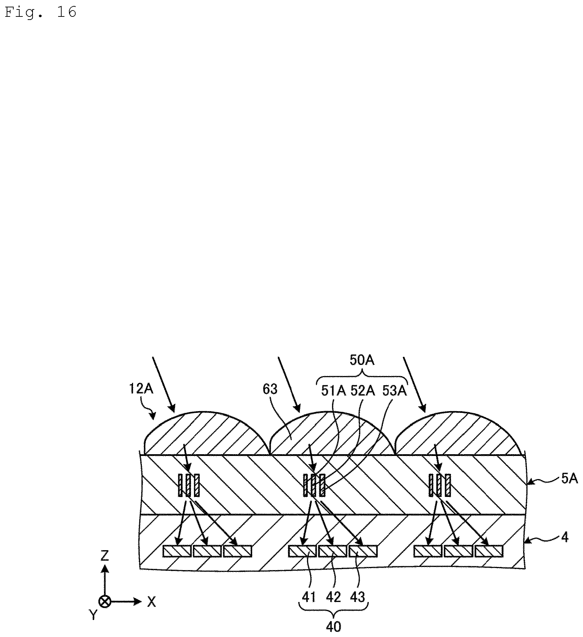

   Fig. 16 is a diagram showing an example of a schematic configuration of an imaging element in an intermediate portion.
[Fig. 17]

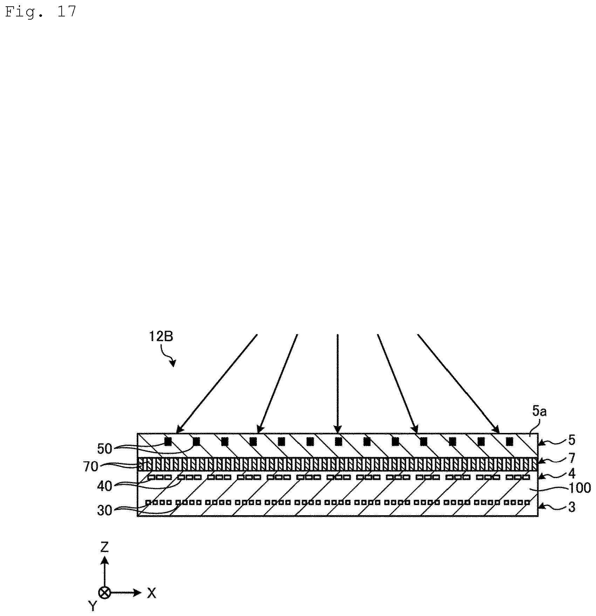

   Fig. 17 is a diagram showing an example of a schematic configuration of an imaging element.
[Fig. 18]

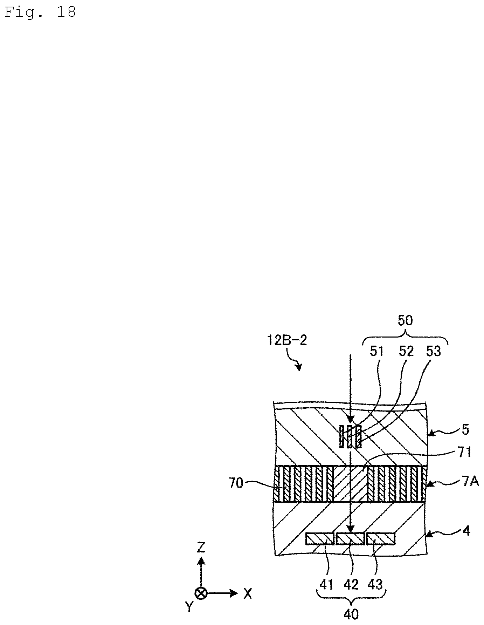

   Fig. 18 is a diagram showing an example of a schematic configuration of an imaging element in a portion of a specific PD.

### [Description of Embodiments]

Hereinafter, an embodiment of the present invention will be described with reference to the accompanying drawings. It is to be understood that shapes, sizes, positional relationships, and the like shown in the drawings are merely schematic and the present invention is not limited thereto. Same portions will be denoted by same reference signs and redundant descriptions will be omitted.

Fig. 1 is a diagram showing an example of a schematic configuration of an imaging element and an imaging apparatus according to an embodiment. An imaging apparatus 10 images an object 1 (subject) by using light from the object 1 as incident light. In this example, the object 1 is shown as an outlined arrow. The incident light is made incident on an imaging element 12 via a lens optical system 11. A signal processing unit 13 processes an electric signal from the imaging element 12 to generate an image signal. As shown in Fig. 1, a direction of light incident on the imaging element 12 (an incidence angle to the imaging element 12) differs depending on a position of the imaging element 12.

Fig. 2 is a diagram showing an example of a schematic configuration of an imaging element. In the diagram, an XYZ coordinate system is shown, and an advancing direction of incident light is schematically shown by an arrow. A Z-axis direction corresponds to a stacking direction of a PD layer 4 and a transparent layer 5 to be described later. An XY planar direction corresponds to a planar direction of these layers.

Hereinafter, a "plan view" indicates viewing in the Z-axis direction (for example, in a Z-axis negative direction) and a "side view" indicates viewing in an X-axis direction or a Y-axis direction (for example, in a Y-axis positive direction). Fig. 2 is a cross-sectional view showing an example of a schematic configuration of the imaging element 12 in a side view.

The imaging element 12 includes a wiring layer 3, a PD (photodiode) layer 4, and a transparent layer 5.

To first describe the PD layer 4 among the wiring layer 3 and the PD layer 4, the PD layer 4 includes a plurality of PD groups 40 which are provided side by side in a planar direction of the layer (which can also be described as being arranged in a two-dimensional direction (in a two-dimensional pattern)). Each PD group 40 includes a plurality of PDs provided side by side in the planar direction of the layer. The plurality of PDs are formed on a semiconductor substrate 100. Charges generated in each PD are converted into an electric signal which becomes a basis of a pixel signal by transistors (not illustrated) or the like and output to the outside of a pixel 2 through the wiring layer 3. Several wirings corresponding to each PD are illustrated as wirings 30.

The transparent layer 5 is an optical element that disperses incident light toward each of the photoelectric conversion elements of the plurality of PD groups 40. An example of the optical element is a meta-surface, and a case where the transparent layer 5 is a meta-surface will be described below. The meta-surface is an element which is made up of a plurality of microstructures having a width equal to or less than a wavelength of light and which may have a two-dimensional structure or a three-dimensional structure. By using a meta-surface for the optical element, a phase and light intensity can be controlled according to characteristics (wavelength, polarization, and incidence angle) of light by merely changing a parameter of the microstructures, and the degree of freedom in design described above is increased in the case of forming a three-dimensional structure. The transparent layer 5 is provided so as to face the PD layer 4, and in this example, the transparent layer 5 is provided on an upper surface (a surface on a Z-axis positive direction side) of the PD layer 4. The transparent layer 5 extends with a planar direction of the PD layer 4 as a planar direction of the layer. The transparent layer 5 includes a plurality of structure groups 50 arranged in a planar direction of the layer. In the example shown in Fig. 2, the plurality of structure groups 50 are provided inside the transparent layer 5. However, the plurality of structure groups 50 may be provided on the transparent layer 5. The plurality of structure groups 50 may be provided on a lower surface of a transparent substrate and, in such a case, the transparent layer 5 is an air layer. The structure constituting the plurality of structure groups 50 is a microstructure having a dimension more or less equal to or smaller than the wavelength (nano-order) of incident light.

A portion of the transparent layer 5 where the structure is not provided may have a refractive index lower than that of the structure. An example of a material of such a transparent layer 5 is SiO₂. The transparent layer 5 may be a void and, in such a case, the refractive index of the transparent layer 5 is the refractive index of air.

As described earlier with reference to Fig. 1, the angle of incident light to the imaging element 12 varies depending on the position on the imaging element 12. In the example shown in Fig. 2, the incidence angle of light to the transparent layer 5 varies depending on two-dimensional positions (positions on the XY plane). In the imaging element 12, the incidence angle in a two-dimensional central portion (hereinafter, also simply referred to as a "central portion") is 0° in this example and, therefore, the light enters the transparent layer 5 perpendicularly. In the imaging element 12, an incidence angle in a two-dimensional outer peripheral portion (hereinafter, also simply referred to as an "outer peripheral portion") deviates from the incidence angle in the central portion. The deviation of the incidence angle becomes larger from the central portion toward the outer peripheral portion.

Figs. 3 and 4 are diagrams showing an example of a schematic configuration of an imaging element in the central portion. Fig. 3 is a cross-sectional view showing an example of a schematic configuration of the imaging element 12 in a side view. Fig. 4 is a diagram showing an example of a schematic configuration of the imaging element 12 in a plan view. Since the PD group 40 is located on a lower side (a Z-axis negative direction side) of the structure group 50, the PD group 40 is indicated by a broken line in Fig. 4.

As a plurality of diodes included in the PD group 40, a PD 41, a PD 42, and a PD 43 are exemplified. The PD 41, the PD 42 and the PD 43 are provided in order in a planar direction of the PD layer 4 (in this example, in the X-axis direction) . It is assumed that light of a wavelength band in accordance with a corresponding color is incident on the PD 41, the PD 42, and the PD 43. For example, the PD 41, the PD 42, and the PD 43 correspond to red (R), green (G), and blue (B).

A structure 51, a structure 52, and a structure 53 are exemplified as a plurality of structures included in the structure group 50. The structure 51, the structure 52, and the structure 53 are a plurality of structures each arranged in a same pattern. The same pattern means that, for example, a size (width) of each structure and intervals in the planar direction of the transparent layer 5 are the same. The size (height) of each structure in the lamination direction may be the same. The structure 51, the structure 52, and the structure 53 are arranged so as to disperse incident light respectively toward the PD 41, the PD 42, and the PD 43 of the corresponding PD group 40. More specifically, the structure 51, the structure 52, and the structure 53 are arranged to disperse incident light toward centers of each of the PD 41, the PD 42, and the PD 43. The incident light is dispersed into, for example, light of a wavelength band corresponding to each color of RGB as described above, and reaches the PD 41, the PD 42, and the PD 43 corresponding to each color. In the examples shown in Figs. 3 and 4, the center of the structure group 50 is located above the center of the PD group 40 (in this example, on the center of the PD 42).

A principle of spectroscopy by the structure 51, the structure 52, and the structure 53 will be described with reference to Figs. 5 and 6. Hereinafter, the structure 51 will be described as an example. The structure 52 and the structure 53 can also be described in the same manner.

Figs. 5 and 6 are diagrams showing an example of a schematic configuration of a structure. Fig. 5 shows an example of a plan view (top view) of the structure 51. Fig. 6 shows an example of a side view of the structure 51.

In this example, the structure 51 is a fine columnar structure. The structure 51 is made of a material such as SiN which has a refractive index n₁ that is higher than a refractive index n₀ of other portions of the transparent layer 5, and a thickness h (a length in the Z-axis direction) of the structure is constant.

A bottom surface and a top surface of the structure 51 are square. The structure 51 acts as an optical waveguide for trapping light inside the structure and propagating the light therein due to a difference in the refractive indexes described above. Accordingly, when light enters from an upper surface side, the light is propagated while being strongly confined inside the structure 51, and the light is subjected to an optical phase delay effect determined by an effective refractive index n_{eff} of the optical waveguide and exits from the bottom surface side. Specifically, when a phase of light having propagated over a length corresponding to the thickness of the transparent layer 5 is used as a benchmark, an optical phase delay amount *φ* by the structure 51 is expressed by *φ* = (n_{eff} - n₀) × 2πh/ *λ*, where *λ* denotes a wavelength of the light in vacuum. Since the optical phase delay amount differs depending on the wavelength *λ*, a different optical phase delay amount in accordance with a wavelength band (color) is given to light incident on the same structure 51. Since the bottom surface and the top surface of the structure 51 are square, there is no change in optical characteristics including an optical phase delay effect even when a polarization direction is changed. It is known that n_{eff} is a function of a structural dimension and takes a value that satisfies n₀ < n_{eff} < n₁. Therefore, by changing the width W of the structure 51, an arbitrary optical phase delay amount can be set. An arbitrary optical phase delay amount can also be set by changing the refractive index of the structure 51. Structures 51 having different refractive indices may be made of materials having different refractive indices. This applies likewise to the structure 52 and the structure 53.

Referring also to Figs. 3 and 4, the structure 51, the structure 52, and the structure 53 have different widths so as to give light having been transmitted through the structure group 50 a different optical phase delay distribution for each wavelength region to change an optical wavefront. Since an outgoing direction (propagation direction) of the light is determined by the optical wavefront, the light transmitted through the structure group 50 is spatially separated according to the corresponding colors (wavelength bands) of the PD 41, the PD 42, and the PD 43. In this way, incident light is dispersed toward the PD 41, the PD 42, and the PD 43, respectively.

Since the structure 51, the structure 52, and the structure 53 are arranged in the same pattern in each of the plurality of structure groups 50, the relationship between an incidence angle and an outgoing angle of light in each of the structure groups 50 is also the same. When the incidence angle is different, the outgoing angle is also different. As described earlier, since the incidence angle in the outer peripheral portion is deviated from the incidence angle in the central portion, the outgoing angle of the light emitted from the transparent layer 5 toward the PD layer 4 is also deviated. When the outgoing angle is deviated, light can no longer be efficiently guided to the PD 41, the PD 42, and the PD 43 of the corresponding PD group 40. Therefore, in the imaging element 12, the relative positions of the PD group 40 and the structure group 50 are determined in correspondence to the deviation of the incidence angle (or an outgoing angle attributable thereto).

Fig. 7 and Fig. 8 are diagrams showing an example of a schematic configuration of an imaging element in an outer peripheral portion. Fig. 7 is a cross-sectional view showing an example of a schematic configuration of the imaging element 12 in a side view. Fig. 8 is a diagram showing an example of a schematic configuration of the imaging element 12 in a plan view.

In the outer peripheral portion, an incidence angle of light incident on the structure group 50 is deviated from the incidence angle (Fig. 3) in the central portion. Due to the deviation of the incidence angle, an outgoing angle of light emitted from the structure group 50 toward the PD group 40 is also deviated. However, the relative positions of the PD group 40 and the structure group 50 are also deviated from the relative positions (Fig. 3 and Fig. 4) in the central portion. In this example, the position of the structure group 50 with respect to the PD group 40 is shifted to a side of the PD 41 of the PD group 40 and, specifically, a center position of the structure group 50 is positioned above a portion on a side of the PD 41 (in this example, above the PD 41) of the PD group 40. A direction (angle) in which the PD group 40 is viewed from the structure group 50 is also deviated by the amount of deviation of the relative positions of the PD group 40 and the structure group 50. The relative positions of the PD group 40 and the structure group 50 are determined so that the deviation of the direction (angle) in which the PD group 40 is viewed from the structure group 50 cancels out the deviation of the outgoing angle described above. As a result, even in the outer peripheral portion, the structure group 50 disperses incident light toward the center of each of the PD 41, the PD 42, and the PD 43.

Supposing that the relative positions of the PD group 40 and the structure group 50 in the outer peripheral portion are the same as the relative positions in the central portion, the light dispersed by the structure group 50 is no longer directed to the center of each of the PD 41, the PD 42, and the PD 43. This state will be described with reference to Fig. 9.

Fig. 9 is a diagram showing a comparative example. In an exemplified imaging element 12E, the relative positions of the PD group 40 and a structure group 50E are the same as the relative positions in the central portion. The light dispersed by a structure 51E, a structure 52E, and a structure 53E reaches a position separated from the center of each of the PD 41, the PD 42, and the PD 43 by an amount of deviation of an outgoing angle attributable to a deviation of an incidence angle. As described earlier with reference to Fig. 7 and Fig. 8, this problem is reduced or eliminated by the imaging element 12 according to the embodiment.

Fig. 10 and Fig. 11 are diagrams showing an example of a schematic configuration of an imaging element in an intermediate portion. The intermediate portion is a portion between the central portion and the outer peripheral portion. Fig. 10 is a cross-sectional view showing an example of a schematic configuration of the imaging element 12 in a side view. Fig. 11 is a diagram showing an example of a schematic configuration of the imaging element 12 in a plan view.

. In the intermediate portion, a deviation of an incidence angle is smaller than a deviation (Fig. 7) of the incidence angle in the outer peripheral portion. A deviation of an outgoing angle that is attributable to the deviation of the incidence angle is also smaller than a deviation of the outgoing angle in the outer peripheral portion. Therefore, the deviation of the relative positions of the PD group 40 and the structure group 50 is also smaller than the deviation of the relative positions in the outer peripheral portion. Also in the intermediate portion, the structure group 50 disperses incident light toward the center of each of the PD 41, the PD 42, and the PD 43.

As described above, for example, in the imaging element 12, the relative positions of the corresponding PD group 40 and the structure group 50 differ according to two-dimensional positions (positions with an XY-planer shape) . More specifically, when relative positions of the PD group 40 and the structure group 50 in the central portion are used as a benchmark, the relative positions deviate more toward the outer peripheral portion. Supposing that the relative positions are the same at any position, the light dispersed by the structure group 50 reaches a position away from the center of each of the PD 41, the PD 42, and the PD 43 as described earlier with reference to Fig. 9. As a result, light is not efficiently incident on the PD 41, the PD 42, and the PD 43 and, for example, problems such as deterioration of light-receiving sensitivity arise. On the other hand, in the imaging element 12, by shifting relative positions of the corresponding PD group 40 and the structure group 50, a spectral direction by the structure group 50 can be brought close to the center of each of the PD 41, the PD 42, and the PD 43. As a result, light-receiving efficiency can be improved.

Once again referring to Fig. 1, the signal processing unit 13 of the imaging apparatus 10 will be described. The signal processing unit 13 generates a pixel signal based on an electrical signal obtained from the imaging element 12. In order to obtain an electric signal, the signal processing unit 13 also controls the imaging element 12. The control of the imaging element 12 includes exposure of the pixel 2 of the imaging element 12, conversion of an electric charge accumulated in the PD layer 4 into an electric signal, reading of the electric signal, and the like.

In the embodiment described above, a method of coping with a problem attributable to a deviation of incident light with relative positions of the PD group 40 and the structure group 50 has been described. Other various methods may be used in addition to or in place of this method.

For example, the incidence angle itself of the light incident on the transparent layer 5 in the outer peripheral portion and the intermediate portion may be made to approach the incidence angle in the central portion. This method will be described with reference to Figs. 12 to 16.

Fig. 12 is a diagram showing an example of a schematic configuration of the imaging element in the central portion. An exemplified imaging element 12A differs from the imaging element 12 (Fig. 3 and the like) in that the imaging element 12A includes a transparent layer 5A in place of the transparent layer 5 and further includes a plurality of lenses 61. The transparent layer 5A includes a plurality of structure groups 50A.

Each of the plurality of lenses 61 is a microlens provided for each of the plurality of structure groups 50A. The lens 61 has a shape in accordance with a two-dimensional position. In this example, the lens 61 does not change the direction of incident light. A structure 51A, a structure 52A, and a structure 53A of the structure group 50A are arranged so as to disperse light from the lens 61 toward the center of each of the PD 41, the PD 42, and the PD 43.

An incidence angle of light incident on the structure group 50A in the outer peripheral portion and the intermediate portion is deviated from the incidence angle (Fig. 12) in the central portion. As an example of a method for reducing this deviation, two methods will be described. In the first method, the principle of shifting the position of a structure group with respect to a PD group described heretofore is also applied to the plurality of lenses 61. The first method will now be described with reference to Figs. 13 and 14.

. Fig. 13 is a diagram showing an example of a schematic configuration of the imaging element in the outer peripheral portion. As compared with the central portion (Fig. 12), the relative positions of the plurality of lenses 61 and the structure group 50 are deviated from the relative positions in the central portion. In this example, the positions of the plurality of lenses 61 with respect to the structure group 50A are shifted to a side of the PD 41 of the PD group 40. The lens 61 is arranged so that an incidence angle of light toward the structure group 50A approaches an incidence angle in the central portion. The structure 51A, the structure 52A, and the structure 53A of the structure group 50A are arranged so as to disperse light from the lens 62 toward the center of each of the PD 41, the PD 42, and the PD 43.

Fig. 14 is a diagram showing an example of a schematic configuration of the imaging element in the intermediate portion. As compared with the central portion (Fig. 12), the relative positions of the plurality of lenses 61 and the structure group 50 are deviated from the relative positions in the central portion. This deviation is smaller than the deviation in the outer peripheral portion (Fig. 13). The lens 61 is arranged so that an incidence angle of light toward the structure group 50A approaches an incidence angle in the central portion. The structure 51A, the structure 52A, and the structure 53A of the structure group 50A are arranged so as to disperse light from the lens 62 toward the center of each of the PD 41, the PD 42, and the PD 43.

The second method is a method of providing a lens having a shape in accordance with a two-dimensional position. This method will be described with reference to Figs. 15 and 16.

Fig. 15 is a diagram showing an example of a schematic configuration of the imaging element in the outer peripheral portion. The imaging element 12A is provided with a plurality of lenses 62 in place of the plurality of lenses 61 in comparison with the central portion (Fig. 12). Each of the plurality of lenses 62 is a microlens provided for each of the plurality of structure groups 50A. The lens 62 is configured so that an incidence angle of light toward the structure group 50 approaches an incidence angle in the central portion. The lens 62 has a shape in accordance with a two-dimensional position which is a shape having been deformed from the shape of the lens 61 (Fig. 12). The structure 51A, the structure 52A, and the structure 53A of the structure group 50A are arranged so as to disperse light from the lens 62 toward the center of each of the PD 41, the PD 42, and the PD 43.

Fig. 16 is a diagram showing an example of a schematic configuration of the imaging element in the intermediate portion. The imaging element 12A is provided with a plurality of lenses 63 in place of the plurality of lenses 61 in comparison with the central portion (Fig. 12). Each of the plurality of lenses 63 is a microlens provided for each of the plurality of structure groups 50A. The lens 63 is configured so that an incidence angle of light toward the structure group 50 approaches an incidence angle in the central portion. The lens 63 has a shape in accordance with a two-dimensional position which is a shape having been deformed from the shape of the lens 61 (Fig. 12). The degree of the deformation is smaller than the degree of deformation of the lens 62 (Fig. 15). The structure 51A, the structure 52A, and the structure 53A of the structure group 50A are arranged so as to disperse light from the lens 63 toward the center of each of the PD 41, the PD 42, and the PD 43.

As shown in Figs. 12 to 16, by differentiating relative positions of the corresponding plurality of lenses 61 and the structure group 50 in accordance with the two-dimensional positions or providing the lens 61, the lens 62 and the lens 63 having a shape in accordance with the two-dimensional positions, an incidence angle of light incident on the transparent layer 5 in the outer peripheral portion and the intermediate portion can be made to approach an incidence angle in the central portion. Therefore, for example, light is more easily dispersed toward the center of each of the PD 41, the PD 42, and the PD 43 of the PD group 40 than when only the plurality of structure groups 50A are used. For example, if the incidence angle in the outer peripheral portion and the intermediate portion can be brought sufficiently close to the incidence angle in the central portion using only the lens 61 or the like, the relative positions of the corresponding structure group 50A and the PD group 40 need not be deviated. This is because each structure group 50A disperses light toward the center of each of the PD 41, the PD 42 and the PD 43.

For example, a reflection suppression layer may be provided to suppress reflection of incident light to the PDs. This method will be described with reference to Figs. 17 and 18.

Fig. 17 is a diagram showing an example of a schematic configuration of an imaging element. An exemplified imaging element 12B differs from the imaging element 12 (Fig. 2) in that the imaging element 12B further includes a reflection suppression layer 7.

The reflection suppression layer 7 is provided so as to cover the PD layer 4 and suppresses reflection of light incident on the PD layer 4. In this example, the reflection suppressing layer 7 is provided between the PD layer 4 and the transparent layer 5.

In the example shown in Fig. 17, the reflection suppressing layer 7 includes a plurality of diffraction gratings 70. The plurality of diffraction gratings 70 are periodically arranged in a planar direction of the reflection suppression layer 7. The plurality of diffraction gratings 70 have an effective refractive index that differs from the refractive index of the PD layer 4. The effective refractive index is a value of the refractive index when it is assumed that the diffraction grating gives a virtual refractive index, in which case the reflection suppressing layer 7 functions as a portion (or a material, a member, or the like) having the effective refractive index. Since a method of realizing a desired effective refractive index by a plurality of periodically-arranged diffraction gratings is known, a brief description will now be given. The effective refractive index is determined by a grating period (arrangement intervals of the diffraction gratings 70 in the XY-planar direction), a grating height (the length of the diffraction gratings 70 in the Z-axis direction), and the like. The grating period may be set equal to or less than the wavelength of the incident light. Examples of a material of the diffraction gratings 70 include resins such as plastic, glass, and the like.

The diffraction grating 70 has an effective refractive index of a magnitude between the refractive index of the PD layer 4 and the refractive index of a portion opposite to the PD layer 4 across the diffraction grating 70. Since the PD layer 4 is formed on the semiconductor substrate 100, the refractive index of the PD layer 4 may be the same as that of the semiconductor substrate 100. In this example, the refractive index of the portion on the opposite side is the refractive index of the transparent layer 5. Since the diffraction grating 70 has an effective refractive index of a magnitude between the refractive indices, the reflection suppression layer 7 reduces discontinuity between the refractive index of the PD layer 4 and the refractive index of the transparent layer 5 and suppresses reflection of light incident on the PD layer 4.

Providing the reflection suppressing layer 7 as shown in Fig. 17 enables reflection of light to be suppressed and enables light to be incident on the PD 41, the PD 42 and the PD 43 in an efficient manner.

Although an example in which the reflection suppressing layer 7 is used together with the transparent layer 5 that includes the plurality of structure groups 50 has been described above, if light can be made incident in a somewhat efficient manner only by the reflection suppressing layer 7, the plurality of structure groups 50 need not be provided. In this case, various known spectroscopic elements may be used instead of the structure groups 50.

In the imaging element 12B described above, a specific PD may not be covered with the diffraction grating 70. An example of the specific PD is a PD which is located immediately below the structure group 50 and on which light from the structure group 50 is vertically incident. Such a specific PD may be covered with a reflection suppression film instead of the diffraction grating 70. This configuration will be described with reference to Fig. 18.

Fig. 18 is a diagram showing an example of a schematic configuration of an imaging element in a specific PD portion. An exemplified imaging element 12B-2 differs from the imaging element 12B (Fig. 17) in that the imaging element 12B-2 includes a reflection suppression layer 7A instead of the reflection suppression layer 7.

The reflection suppression layer 7A includes a reflection suppression film 71 in addition to a plurality of diffraction gratings 70A. The plurality of diffraction gratings 70A cover the PD 41 and the PD 43 while the PD 42 is not covered but exposed. Since the configuration of the diffraction grating 70A is the same as that of the diffraction grating 70, a description thereof will not be repeated. The reflection suppression film 71 is provided so as to cover the exposed PD 42 in a gapless manner. The reflection suppression film 71 has a refractive index that differ from that of the PD group 40. The PD 42 is a photoelectric conversion element corresponding to, for example, green (G). Examples of a material of the reflection suppressing film 71 include resins such as plastic, glass, or the like.

As shown in Fig. 18, by using the reflection suppression layer 7A that includes the two kinds of reflection suppression members, namely, the plurality of diffraction gratings 70 and the reflection suppression film 71, for example, a reflection suppression amount can be adjusted for each of the PD 41, the PD 42, and the PD 43.

In the above embodiment, an example in which the plurality of structure groups 50 are provided in the transparent layer 5 has been described. However, the plurality of structure groups 50 may be provided on the surface on the transparent layer 5 (for example, on a surface on the Z-axis positive direction side).

While SiN and TiO₂ have been cited as materials for the structure 51 and the like in the embodiment described above, materials are not limited thereto. For example, SiN, SiC, TiO₂, GaN, and the like may be used as materials for the structure 51 and the like with respect to light (visible light to near-infrared light) with a wavelength ranging from 380 nm to 1000 nm. These materials are suitable due to their high refractive index and a small absorption loss. Si, SiC, SiN, TiO₂, GaAs, GaN, and the like may be used as materials for the structure 51 and the like with respect to light (near-infrared light) with a wavelength ranging from 800 nm to 1000 nm. These materials are suitable due to their low loss. With respect to light in a near-infrared region of a long wavelength band (such as 1.3 µm and 1.55 µm which are communication wavelengths), InP or the like can be used as a material of the structure 51 or the like in addition to the materials described above.

When the structure 51 and the like are formed through adhesion, coating, and the like, examples of materials include a polyimide such as fluorinated polyimide, BCB (benzocyclobutene), a photocurable resin, a UV epoxy resin, an acrylic resin such as PMMA, and a polymer such as a general resist.

While an example in which SiO₂ and an air layer are assumed as materials of the transparent layer 5 has been shown in the embodiment described above, materials of the transparent layer 5 are not limited thereto. Any material including a general glass material may be used as long as a refractive index of the material is smaller than that of the refractive index of the material of the structure 51 and the like and has low loss with respect to the wavelength of incident light. The transparent layer 5 may be a transparent layer having a laminated structure made up of a plurality of materials. Furthermore, since a transparent layer 60 need only have sufficiently low loss with respect to a wavelength which is to reach a corresponding PD, the transparent layer 60 may be made of a same material as that of a color filter or made of an organic material such as a resin.

While the three primary colors of RGB have been described as an example of colors that the PD 41, the PD 42, and the PD 43 correspond to in the embodiment described above, the PD 41, the PD 42, and the PD 43 may correspond to light (for example, infrared light or ultraviolet light) having wavelengths other than the three primary colors.

While an example in which one PD group 40 includes three PDs, namely, the PD 41, the PD 42, and the PD 43 has been described in the embodiment described above, one PD group may include two or four or more PDs. These PDs may be arranged in a one-dimensional direction (for example, in the X-axis direction or the Y-axis direction) or in a two-dimensional direction (for example, in the X-axis direction and the Y-axis direction) .

While the present invention has been described based on a specific embodiment, it is obvious that the present invention is not limited to the foregoing embodiment and can be modified in various ways without departing from the invention.

For example, the imaging element described above is specified as follows. As described with reference to Figs. 1 to 11 and the like, an imaging element 12 includes a plurality of PD groups 40, a transparent layer 5, and a plurality of structure groups 50. Each of the plurality of PD groups 40 includes a PD 41, a PD 42, and a PD 43 and is arranged in a two-dimensional direction (an XY planar direction). The transparent layer 5 faces the plurality of PD groups 40 and extends with a two-dimensional direction as a planar direction. The plurality of structure groups 50 are arranged on the transparent layer 5 or in the transparent layer 5 in a planar direction of the transparent layer 5 corresponding to the plurality of PD groups 40. Each of the plurality of structure groups 50 includes a structure 51, a structure 52, and a structure 53 arranged in the same pattern, and is arranged so as to disperse incident light toward each of the PD 41, the PD 42, and the PD 43 of the corresponding PD group 40. In a plan view, the relative positions of the corresponding PD group 40 and the structure group 50 differ according to two-dimensional positions (positions on an XY plane).

In the imaging element 12, the relative positions of the corresponding PD group 40 and the structure group 50 differ according to two-dimensional positions. Assuming that the relative positions are the same at any two-dimensional position, as described earlier with reference to Fig. 9, light dispersed by the structure group 50 reaches a position away from the center of each of the PD 41, the PD 42, and the PD 43. As a result, light is not efficiently incident on the PD 41, the PD 42, and the PD 43 and, for example, problems such as deterioration of light-receiving sensitivity arise. On the other hand, in the imaging element 12, by shifting relative positions of the corresponding PD group 40 and the structure group 50, a spectral direction by the structure group 50 can be brought close to the center of each of the PD 41, the PD 42, and the PD 43. Therefore, light-receiving sensitivity can be improved.

When a relative position in a two-dimensional central portion in the imaging element 12 is used as a benchmark, a deviation of the relative position becomes larger toward a two-dimensional outer peripheral portion. Thus, a relative position corresponding to the deviation of the incidence angle which becomes larger toward the outer peripheral portion can be determined.

As described with reference to Figs. 5 and 6 and the like, the structure 51, the structure 52 and the structure 53 are columnar structures having a refractive index that is higher than a refractive index of portions therebetween, at least some structures among the structure 51, the structure 52, and the structure 53 have widths that differ from each other in a plan view, and the structure 51, the structure 52, and the structure 53 may have a same height in a side view. At least some structures among the structure 51, the structure 52, and the structure 53 may have different refractive indices from each other. For example, by arranging the structure 51, the structure 52, and the structure 53 configured as described above, the structure group 50 (the transparent layer 5) can be equipped with a spectroscopic function and incident light can be dispersed toward the PD 41, the PD 42 and the PD 43, respectively. Furthermore, the structures can be manufactured more easily than, for example, a case where a plurality of structures having different heights are provided.

As described with reference to Figs. 12 to 14 and the like, the imaging element 12A includes a plurality of lenses 61 each provided so as to correspond to each of a plurality of structure groups 50A, and relative positions of the corresponding structure groups 50A and the lenses 61 may differ according to two-dimensional positions in a plan view. Alternatively, as described with reference to Fig. 12, Fig. 15, Fig. 16, and the like, the imaging element 12A may include a lens 61, a lens 62, and a lens 63, each of which is provided with respect to each of the plurality of structure groups 50A and which has a shape in accordance with a two-dimensional position. Therefore, an incidence angle of light that is incident on the transparent layer 5A in the outer peripheral portion and the intermediate portion can be made to approach an incidence angle in the central portion. For example, light is more easily dispersed toward the center of each of the PD 41, the PD 42, and the PD 43 of the PD group 40 than when only the plurality of structure groups 50 are used.

As described with reference to Fig. 17 and the like, the imaging element 12B may include a plurality of diffraction gratings 70 which are periodically provided so as to cover at least a part of the plurality of PD groups 40 and which have an effective refractive index with a magnitude that differs from the refractive index of the plurality of PD groups 40. Accordingly, reflection of light is suppressed and light can be made incident on the PD 41, the PD 42 and the PD 43 in an efficient manner.

As described with reference to Fig. 18 and the like, the plurality of diffraction gratings 70 expose the PD 42 among the PD 41, the PD 42, and the PD 43 included in each of the plurality of PD groups 40 without covering the PD 42, and the imaging element 12 may include a reflection suppression film 71 which is provided so as to cover the exposed PD 42 in a gapless manner and which has a refractive index that differs from the refractive index of the plurality of PD groups 40. For example, by using the reflection suppressing layer 7A including the two kinds of reflection suppression members, namely, the plurality of diffraction gratings 70 and the reflection suppression film 71, a reflection suppressing amount can be adjusted for each of the PD 41, the PD 42 and the PD 43.

The imaging apparatus 10 described with reference to Fig. 1 and the like is also an aspect of the present disclosure. Specifically, the imaging apparatus 10 includes an imaging element 12 and a signal processing unit 13 for generating an image signal on the basis of an electric signal obtained from the imaging element 12. Accordingly, the imaging apparatus 10 capable of improving light-receiving efficiency can be obtained.

### [Reference Signs List]

- 3: Wiring layer
- 4: PD layer
- 5: Transparent layer
- 7: Reflection suppression layer
- 10: Imaging apparatus
- 12: Imaging element
- 13: Signal processing unit
- 40: PD group
- 41: PD
- 42: PD
- 43: PD
- 50: Structure group
- 51: Structure
- 52: Structure
- 53: Structure
- 61: Lens
- 62: Lens
- 63: Lens
- 70: Diffraction grating
- 71: Reflection suppression film

## Claims

1. An imaging element (12), comprising:
a plurality of photoelectric conversion element groups (40) each including a plurality of photoelectric conversion elements (41, 42, 43) and being arranged in a two-dimensional direction;
a transparent layer (5) which faces the plurality of photoelectric conversion element groups and which extends in the two-dimensional direction as a planar direction;
a plurality of structure groups (50) arranged in a planar direction of the transparent layer so as to correspond to the plurality of photoelectric conversion element groups on the transparent layer or inside the transparent layer, wherein
each of the plurality of structure groups (50) includes a plurality of structures (51, 52, 53) arranged in a same pattern and in the planar direction of the transparent layer and arranged so as to disperse incident light toward each of the photoelectric conversion elements (41, 42, 43) of a corresponding photoelectric conversion element group,
wherein in a plan view, relative positions of the corresponding photoelectric conversion element group (40) and a structure group (50) differ depending on their positions in the two-dimensional plane (XY), and wherein when the relative positions at a central portion in the two-dimensional plane are used as a benchmark, the relative positions deviate more toward an outer periphery portion of the two-dimensional plane.

2. The imaging element (12) according to claim 1, wherein
the plurality of structures (51 to 53) are columnar structures having a refractive index that is higher than a refractive index of portions between the plurality of structures,
in a plan view, at least some structures among the plurality of structures have widths that differ from each other, and
in a side view, the plurality of structures have a same height.

3. The imaging element (12) according to claim 1, wherein
the plurality of structures (51 to 53) are columnar structures having a refractive index that is higher than a refractive index of portions between the plurality of structures, wherein
at least some structures among the plurality of structures have different refractive indices from each other, and
in a side view, the plurality of structures have a same height.

4. The imaging element (12) according to any one of claims 1 to 3, including:
a plurality of lenses (61 to 63) each provided corresponding to each of the plurality of structure groups, wherein
in a plan view, relative positions of a corresponding structure group and the lens differ according to two-dimensional positions.

5. The imaging element (12) according to any one of claims 1 to 3, including:
a plurality of lenses (61 to 63) each provided corresponding to each of the plurality of structure groups and having a shape according to the two-dimensional positions.

6. The imaging element (12) according to any one of claims 1 to 5, including:
a plurality of diffraction gratings (70) which are periodically provided so as to cover at least a part of the plurality of photoelectric conversion element groups and which have an effective refractive index with a magnitude which differs from that of a refractive index of the plurality of photoelectric conversion element groups.

7. The imaging element (12) according to claim 6, wherein
the plurality of diffraction gratings (70) do not cover a specific photoelectric conversion element among a plurality of photoelectric conversion elements included in each of the plurality of photoelectric conversion element groups and causes the specific photoelectric conversion element to be exposed, and
the imaging element (12) includes a film which is provided so as to cover the exposed photoelectric conversion element in a gapless manner and which has a refractive index with a magnitude which differs from that of a refractive index of the plurality of photoelectric conversion element groups.

8. An imaging apparatus (10), comprising:
the imaging element (12) according to any one of claims 1 to 7; and
a signal processing unit (13) configured to generate an image signal based on an electric signal obtained from the imaging element.

## Patentansprüche

1. Bildgebungselement (12), umfassend:
eine Vielzahl von photoelektrischen Wandlerelementgruppen (40), die jeweils eine Vielzahl von photoelektrischen Wandlerelementen (41, 42, 43) einschließen und in einer zweidimensionalen Richtung angeordnet sind;
eine transparente Schicht (5), die der Vielzahl von photoelektrischen Wandlerelementgruppen zugewandt ist und sich in der zweidimensionalen Richtung als planare Richtung erstreckt;
eine Vielzahl von Strukturgruppen (50), die in einer planaren Richtung der transparenten Schicht angeordnet sind, so dass sie der Vielzahl von photoelektrischen Wandlerelementgruppen auf der transparenten Schicht oder innerhalb der transparenten Schicht entsprechen, wobei
wobei jede der Vielzahl von Strukturgruppen (50) eine Vielzahl von Strukturen (51, 52, 53) einschließt, die in einem gleichen Muster und in der planaren Richtung der transparenten Schicht angeordnet sind und die so angeordnet sind, dass sie einfallendes Licht in Richtung eines jeden der photoelektrischen Wandlerelemente (41, 42, 43) einer entsprechenden photoelektrischen Wandlerelementgruppen streuen,
wobei sich in einer Draufsicht die relativen Positionen der entsprechenden photoelektrischen Wandlerelementgruppe (40) und einer Strukturgruppe (50) in Abhängigkeit von ihren Positionen in der zweidimensionalen planaren Fläche (XY) unterscheiden, und wobei,
wenn die relativen Positionen an einem zentralen Abschnitt in der zweidimensionalen planaren Fläche als Maßstab verwendet werden, die relativen Positionen stärker in Richtung eines äußeren Randabschnitts der zweidimensionalen Ebene abweichen.

2. Bildgebungselement (12) nach Anspruch 1, wobei die Vielzahl von Strukturen (51 bis 53) säulenförmige Strukturen sind, die einen Brechungsindex aufweisen, der höher ist als ein Brechungsindex von Abschnitten zwischen der Vielzahl von Strukturen,
in einer Draufsicht mindestens einige Strukturen unter der Vielzahl von Strukturen Breiten aufweisen, die sich voneinander unterscheiden und
in einer Seitenansicht die Vielzahl von Strukturen dieselbe Höhe aufweist.

3. Bildgebungselement (12) nach Anspruch 1, wobei die Vielzahl von Strukturen (51 bis 53) säulenförmige Strukturen sind, die einen Brechungsindex aufweisen, der höher ist als ein Brechungsindex von Abschnitten zwischen der Vielzahl von Strukturen, wobei
mindestens einige Strukturen unter der Vielzahl von Strukturen Brechungsindizes aufweisen, die sich voneinander unterscheiden und
in einer Seitenansicht die Vielzahl von Strukturen dieselbe Höhe aufweist.

4. Bildgebungselement (12) nach einem der Ansprüche 1 bis 3, einschließlich:
einer Vielzahl von Linsen (61 bis 63), die jeweils entsprechend jeder der Vielzahl von Strukturgruppen bereitgestellt werden, wobei
in einer Draufsicht die relativen Positionen einer entsprechenden Strukturgruppe und der Linse gemäß den zweidimensionalen Positionen unterschiedlich sind.

5. Bildgebungselement (12) nach einem der Ansprüche 1 bis 3, einschließlich:
einer Vielzahl von Linsen (61 bis 63), die jeweils entsprechend jeder der Vielzahl von Strukturgruppen bereitgestellt werden und eine Form gemäß den zweidimensionalen Positionen aufweisen.

6. Bildgebungselement (12) nach einem der Ansprüche 1 bis 5, einschließlich:
eine Vielzahl von Beugungsgittern (70), die periodisch bereitgestellt werden, um mindestens einen Teil der Vielzahl von photoelektrischen Wandlerelementgruppen zu bedecken, und die einen effektiven Brechungsindex mit einer Größe aufweisen, die sich von der eines Brechungsindex der Vielzahl von photoelektrischen Wandlerelementgruppen unterscheidet.

7. Bildgebungselement (12) nach Anspruch 6, wobei
die Vielzahl von Beugungsgittern (70) ein bestimmtes photoelektrisches Wandlerelement unter einer Vielzahl von photoelektrischen Wandlerelementen, die in jeder der Vielzahl von photoelektrischen Wandlerelementgruppen eingeschlossen sind, nicht abdeckt und bewirkt, dass das bestimmte photoelektrische Wandlerelement belichtet wird, und
wobei das Bildgebungselement (12) einen Film einschließt, der so bereitgestellt ist, dass er das belichtete photoelektrische Wandlerelement lückenlos bedeckt, und der einen Brechungsindex mit einer Größe aufweist, die sich von der eines Brechungsindex der Vielzahl von photoelektrischen Wandlerelementgruppen unterscheidet.

8. Bildgebende Einrichtung (10), umfassend:
das Bildgebungselement (12) nach einem der Ansprüche 1 bis 7; und
eine Signalverarbeitungseinheit (13), die so konfiguriert ist, dass sie ein Bildsignal auf der Grundlage eines elektrischen Signals erzeugt, das von dem Bildelement erhalten wird.

## Revendications

1. Élément d'imagerie (12), comprenant :
une pluralité de groupes d'éléments de conversion photoélectrique (40), chacun incluant une pluralité d'éléments de conversion photoélectrique (41, 42, 43) et étant agencé dans une direction bidimensionnelle ;
une couche transparente (5) qui fait face à la pluralité de groupes d'éléments de conversion photoélectrique et qui s'étend dans la direction bidimensionnelle en tant qu'une direction planaire ;
une pluralité de groupes de structures (50) agencés dans une direction planaire de la couche transparente de manière à correspondre à la pluralité de groupes d'éléments de conversion photoélectrique sur la couche transparente ou à l'intérieur de la couche transparente, dans lequel
chaque groupe de structures de la pluralité de groupes de structures (50) inclut une pluralité de structures (51, 52, 53) agencées dans un même motif et dans la direction planaire de la couche transparente et agencées de manière à disperser une lumière incidente vers chacun des éléments de conversion photoélectrique (41, 42, 43) d'un groupe d'éléments de conversion photoélectrique correspondant,
dans lequel
dans une vue en plan, des positions relatives du groupe d'éléments de conversion photoélectrique (40) correspondant et d'un groupe de structures (50) diffèrent en fonction de leurs positions dans le plan bidimensionnel (XY),
et dans lequel
lorsque les positions relatives au niveau d'une partie centrale dans le plan bidimensionnel sont utilisées comme une référence, les positions relatives dévient davantage vers une partie périphérique extérieure du plan bidimensionnel.

2. Élément d'imagerie (12) selon la revendication 1, dans lequel la pluralité de structures (51 à 53) sont des structures colonnaires présentant un indice de réfraction qui est supérieur à un indice de réfraction de parties entre la pluralité de structures,
dans une vue en plan, au moins certaines structures parmi la pluralité de structures présentent des largeurs qui diffèrent les unes des autres, et
dans une vue latérale, la pluralité de structures présentent une même hauteur.

3. Élément d'imagerie (12) selon la revendication 1, dans lequel la pluralité de structures (51 à 53) sont des structures colonnaires présentant un indice de réfraction qui est supérieur à un indice de réfraction de parties entre la pluralité de structures, dans lequel
au moins certaines structures parmi la pluralité de structures présentent des indices de réfraction différents les uns des autres, et
dans une vue latérale, la pluralité de structures présentent une même hauteur.

4. Élément d'imagerie (12) selon l'une quelconque des revendications 1 à 3, incluant :
une pluralité de lentilles (61 à 63), chacune prévue en correspondance avec chaque groupe de structures de la pluralité de groupes de structures, dans lequel
dans une vue en plan, des positions relatives d'un groupe de structures correspondant et de la lentille diffèrent selon des positions bidimensionnelles.

5. Élément d'imagerie (12) selon l'une quelconque des revendications 1 à 3, incluant :
une pluralité de lentilles (61 à 63), chacune prévue en correspondance avec chaque groupe de structures de la pluralité de groupes de structures et présentant une forme selon les positions bidimensionnelles.

6. Élément d'imagerie (12) selon l'une quelconque des revendications 1 à 5, incluant :
une pluralité de grilles de diffraction (70) qui sont périodiquement prévues de manière à couvrir au moins une partie de la pluralité de groupes d'éléments de conversion photoélectrique et qui présentent un indice de réfraction efficace avec une amplitude qui diffère de celle d'un indice de réfraction de la pluralité de groupes d'éléments de conversion photoélectrique.

7. Élément d'imagerie (12) selon la revendication 6, dans lequel
la pluralité de grilles de diffraction (70) ne couvrent pas un élément de conversion photoélectrique spécifique parmi une pluralité d'éléments de conversion photoélectrique inclus dans chacun de la pluralité de groupes d'éléments de conversion photoélectrique et amènent l'élément de conversion photoélectrique spécifique à être exposé, et
l'élément d'imagerie (12) inclut un film qui est prévu de manière à couvrir sans interstices l'élément de conversion photoélectrique et qui présente un indice de réfraction avec une amplitude qui diffère de celle d'un indice de réfraction de la pluralité de groupes d'éléments de conversion photoélectrique.

8. Appareil d'imagerie (10), comprenant :
l'élément d'imagerie (12) selon l'une quelconque des revendications 1 à 7 ; et
une unité (13) de traitement de signal configurée pour générer un signal d'image sur la base d'un signal électrique obtenu à partir de l'élément d'imagerie.
